(19) Europäisches Patentamt
European Patent Office
Office européen des brevets

(11) **EP 3 685 955 A1**

(12) **EUROPEAN PATENT APPLICATION**
published in accordance with Art. 153(4) EPC

(43) Date of publication:
**29.07.2020 Bulletin 2020/31**

(51) Int Cl.:
***B23K 26/064*** *(2014.01)*    ***B23K 26/00*** *(2014.01)*
***G02B 6/02*** *(2006.01)*

(21) Application number: **18857808.2**

(22) Date of filing: **11.09.2018**

(86) International application number:
**PCT/JP2018/033522**

(87) International publication number:
**WO 2019/059031 (28.03.2019 Gazette 2019/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.09.2017  JP 2017181746**

(71) Applicant: **Panasonic Intellectual Property Management Co., Ltd.**
**Osaka-shi, Osaka 540-6207 (JP)**

(72) Inventors:
• **NAGAYASU, Doukei**
  **Osaka-shi**
  **Osaka 540-6207 (JP)**
• **YAMASHITA, Takayuki**
  **Osaka-shi**
  **Osaka 540-6207 (JP)**

• **HOSHINO, Kenji**
  **Osaka-shi**
  **Osaka 540-6207 (JP)**
• **YAMAGUCHI, Hideaki**
  **Osaka-shi**
  **Osaka 540-6207 (JP)**
• **KATO, Naoya**
  **Osaka-shi**
  **Osaka 540-6207 (JP)**
• **ISHIKAWA, Ryo**
  **Osaka-shi**
  **Osaka 540-6207 (JP)**
• **DOMOTO, Shinya**
  **Osaka-shi**
  **Osaka 540-6207 (JP)**
• **EIZUMI, Kiyotaka**
  **Osaka-shi**
  **Osaka 540-6207 (JP)**

(74) Representative: **Vigand, Philippe et al**
**Novagraaf International SA**
**Chemin de l'Echo 3**
**1213 Onex - Genève (CH)**

(54) **PROCESS FIBER AND LASER PROCESSING SYSTEM IN WHICH SAME IS USED**

(57)    A process fiber (20) includes a first light transmitter configured to transmit the processing laser beam emitted from a processing laser source (12) of a laser processing system (1); a measuring laser source (14); and a second light transmitter fixed to the first light transmitter along the length of the first light transmitter and configured to transmit the measuring laser beam emitted from the measuring laser source (14). The bending radius of the first light transmitter at a predetermined position is detected based on the measuring laser beam reflected by the second light transmitter.

FIG. 1

EP 3 685 955 A1

**Description**

**BACKGROUND ART**

The present disclosure relates to a process fiber and a laser processing system including the fiber.

**BACKGROUND ART**

Laser processing systems have been widely used in which a direct diode laser (DDL) source emits a high-power processing laser beam, which is transmitted through a process fiber to the processing head and applied to a workpiece so as to weld, cut, or perforate the workpiece.

To make laser processing more productive, the position and angle of the processing head with respect to the workpiece should be moved or rotated at high speed. To achieve this, the bending radius of the process fiber is controlled so that it will not be smaller than the allowable value during the laser processing. In particular, in the case of transmitting a high-power processing laser beam, bending the process fiber too much may cause the high-power laser beam to leak from the core to the clad in the optical fiber composing the process fiber. This can undesirably reduce the output of the laser beam, possibly damaging the process fiber.

For example, in PTL 1, the optical fiber cable (process fiber) optically connecting the laser oscillator with the processing head is hung from at least two spring balancers at least two points. This allows the laser processor to move the processing head omnidirectionally under fewer constraints in the control of movement and posture.

Meanwhile, PTL 2 discloses an optical fiber cable having a stiffness high enough to bend flexibly up to the fracture curvature (allowable bending radius) and low enough not to bend over the fracture curvature. The optical fiber cable shown in FIG. 1 of PTL 2 transmits a laser beam for laser processing. This fiber cable has a double pipe structure formed of a plurality of independent inner pipes around the fiber wires and a plurality of independent outer pipes around the inner pipes. Each of the inner pipes is fixed to the adjacent outer pipe with pins.

When the optical fiber cable of PTL 2 thus structured is bent, each inner pipe is trying to bend accordingly, but is prevented by the outer pipe fixed to the inner pipe with the pins. As a result, the optical fiber cable as a whole never bends largely over the fracture curvature.

**Citation List**

Patent Literature

PTL 1: Japanese Unexamined Patent Application Publication No. 2010-214437
PTL 2: Japanese Unexamined Utility Model Application Publication No. 60-19007

**SUMMARY**

**Technical Problem**

The optical fiber cable shown in PTL 1 is hung from the spring balancers so as to somewhat reduce the constraints in the control of movement and posture of the processing head. However, the fiber cable can be bent to a radius smaller than the allowable bending radius by unexpected movements or postures.

Although the optical fiber cable of PTL 2 does not bend largely over the fracture curvature, the inner pipes fixed with pins to the outer pipes result in an increase in the mass (weight) of the cable. This obstructs moving or rotating the processing head connected to the fiber cable at high speed.

In view of the above problems, an object of the present disclosure is to provide a process fiber that is unlikely to bend to a radius smaller than the allowable bending radius while the processing head is in action.

**Solution to Problem**

The process fiber according to the present disclosure is a process fiber including: a first light transmitter configured to transmit a processing laser beam emitted from a processing laser source of a laser processing system; a measuring laser source configured to emit a measuring laser beam; and a second light transmitter including a reflection part configured to reflect the measuring laser beam, the second light transmitter being fixed to the first light transmitter along the length of the first light transmitter and being configured to transmit the measuring laser beam, wherein the bending radius of the first light transmitter at a predetermined position is detected based on the measuring laser beam reflected by the reflection part.

## Advantageous Effects of the Invention

The process fiber according to the exemplary embodiments of the present disclosure is easily prevented from bending to a radius smaller than the allowable bending radius while the processing head is in action.

## BRIEF DESCRIPTION OF DRAWINGS

FIG. 1 is a block diagram showing a schematic configuration of a laser processing system according to the present disclosure.
FIG. 2 is a partially cutaway plan view showing a schematic configuration of a process fiber according to the first exemplary embodiment.
FIG. 3 is a plan view showing a schematic configuration of a measuring fiber in the first exemplary embodiment.
FIG. 4 is a partially cutaway plan view showing a schematic configuration of a process fiber according to a modified example of the first exemplary embodiment.
FIG. 5 is a plan view showing a schematic configuration of a measuring fiber in the modified example of the first exemplary embodiment.

## Description of Embodiments

First, the schematic configuration of the present disclosure will be described as follows. The laser processing system according to the present disclosure includes the following components: a processing laser source; a first light transmitter (processing fiber) that transmits the processing laser beam emitted from the processing laser source; a measuring laser source; a second light transmitter (measuring fiber) fixed to the first light transmitter along the length of the first light transmitter so as to transmit the measuring laser beam emitted from the measuring laser source; and a controller that detects the bending radius of the first light transmitter at a predetermined position, based on the measuring laser beam reflected by the second light transmitter at its reflection part.
In the laser processing system, the controller detects the bending radius of the first light transmitter based on the fluctuations in the wavelength of the measuring laser beam reflected by the reflection part of the second light transmitter, thereby detecting the allowable bending radius of the first light transmitter. Furthermore, before the workpiece is actually laser-processed, the controller can properly program the operation of the manipulator such that the processing fiber is not bent to a radius smaller than the allowable bending radius.
In the laser processing system, the bending radius of the first light transmitter may be detected by using fiber Bragg grating (FBG). More specifically, the second light transmitter may include at least one strain sensor (FBG) at a predetermined position, and the at least one strain sensor may reflect the measuring laser beam having a specific peak wavelength. The controller may detect the bending radius of the first light transmitter at the predetermined position based on the measuring laser beam reflected by the strain sensor.
The second light transmitter may include a photonic crystal fiber, and the fiber Bragg grating may be configured to reflect the measuring laser beam having a specific wavelength.
The at least one strain sensor may include a plurality of strain sensors, and the plurality of strain sensors may be configured to reflect a plurality of measuring laser beams each having a specific wavelength. The controller may detect the bending radii of the first light transmitter at a plurality of predetermined positions based on the plurality of measuring laser beams reflected by the plurality of strain sensors.
In the laser processing system, the bending radius of the first light transmitter may be detected by using, for example, FBI-Gauge system. The measuring laser source may have a wavelength-variable light source, and the controller may detect the bending radius of the first light transmitter at the predetermined position based on Rayleigh scattered light reflected by the second light transmitter.
The laser processing system may further include a processing head located at the emission end of the first light transmitter; and a manipulator that adjusts the position and orientation of the processing head. The controller may control the manipulator so as to detect either the bending radius of the first light transmitter at a predetermined position or the bending radii of the first light transmitter at the plurality of predetermined positions, the predetermined position and the plurality of predetermined positions being in the vicinity of the processing head. The first light transmitter is likely to have trouble when bending, at a position in the vicinity of the processing head, to a radius smaller than the allowable bending radius. Therefore, detecting the bending radius of the first light transmitter at a position in the vicinity of the processing head can help to prevent trouble from occurring.

Next, the laser processing system according to the exemplary embodiments of the present disclosure that includes a process fiber will be described as follows with reference to the drawings. In the description of these embodiments, positional terms such as "distal" and "proximal" are used for easier understanding, but do not intend to limit the present disclosure. In these drawings, to make their shape and features recognizable, the components of the laser processing system are not necessarily illustrated in the same scale ratio.

## FIRST EXEMPLARY EMBODIMENT

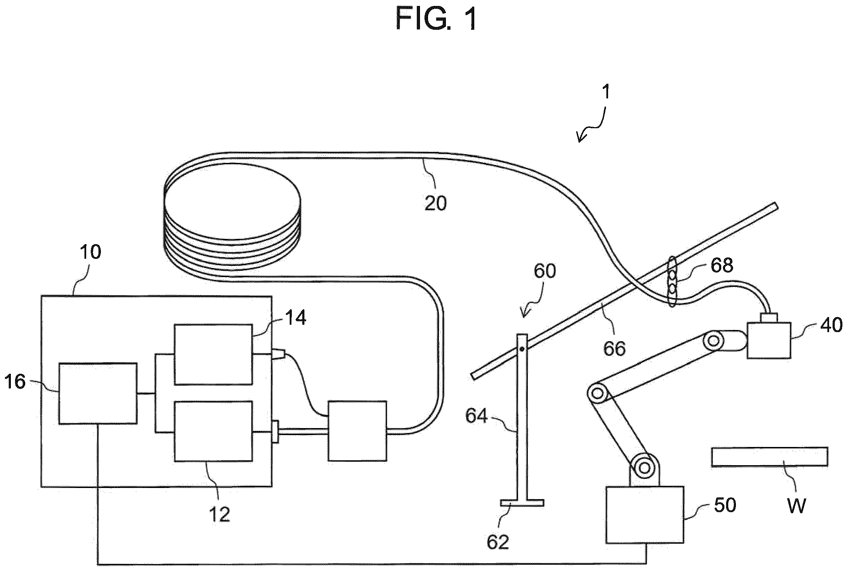

Laser processing system 1 according to the first exemplary embodiment of the present disclosure will now be descried with reference to FIGS. 1 to 3. FIG. 1 is a block diagram showing a schematic configuration of laser processing system 1 according to the present disclosure. System 1 mainly includes the following components: laser oscillator 10; process fiber 20; processing head 40 located at the emission end (distal end) of process fiber 20; manipulator 50 that adjusts the position and angle of head 40; and fiber holding mechanism 60 that holds process fiber 20 flexibly.

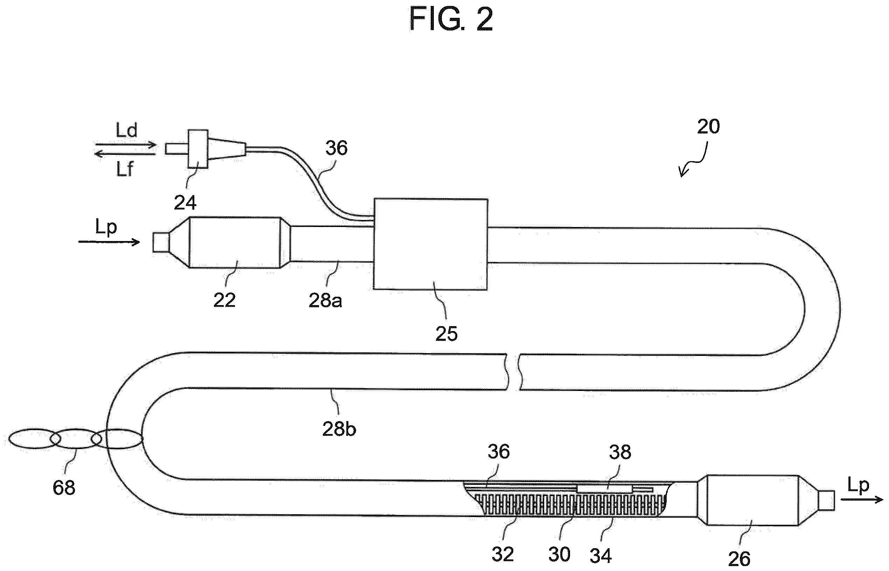

Laser oscillator 10 shown in FIG. 1 includes the following components: processing laser source 12 that emits a processing laser beam Lp (FIG. 2) to processing fiber 30 (i.e., first light transmitter shown in FIG. 2) of process fiber 20; measuring laser transceiver 14 that emits a measuring laser beam Ld (FIG. 2) to measuring fiber 36 (i.e., second light transmitter shown in FIG. 2) of process fiber 20 and that receives the reflected beam Lf (FIG. 2) from measuring fiber 36; and controller 16. Processing laser source 12 may be, but not limited to, a direct diode laser (DDL) source that emits a high-power processing laser beam Lp.

Although not illustrated in detail, measuring laser transceiver 14 in the first exemplary embodiment includes a semiconductor laser that emits a single-mode laser beam Ld (a measuring laser beam Ld) having a peak wavelength of, for example, 1550 nm; and a photodiode that receives the reflected beam of the measuring laser beam Ld (hereinafter referred to simply as "reflected beam") from process fiber 20. The photodiode may be of a type that receives the reflected beam Lf having a predetermined wavelength range including a peak center of, for example, 1550 nm.

Controller 16 controls the intensity of the processing laser beam Lp emitted from processing laser source 12 and the intensity of the measuring laser beam Ld emitted from the semiconductor laser of measuring laser transceiver 14. Controller 16 can also detect the intensity and wavelength of the reflected beam Lf received by the photodiode of measuring laser transceiver 14.

Controller 16 controls manipulator 50 so as to adjust the position and angle of processing head 40. Fiber holding mechanism 60 includes the following components, as shown in FIG. 1: column 64 supported rotatably on base 62; arm 66 supported by column 64 and extending horizontally; and hook 68 suspended from arm 66 and horizontally movable. Fiber holding mechanism 60 holds process fiber 20 by hanging it at its proximal end in the vicinity of processing head 40 (e.g., about 4 m from head 40) such that fiber 20 is movable.

As described above, controller 16 controls the intensity of the processing laser beam Lp emitted from processing laser source 12 and also controls manipulator 50 so as to adjust the position and angle of processing head 40. Under the control of controller 16, the processing laser beam Lp is applied to a workpiece W so as to weld, cut, or perforate it.

FIG. 2 is a partially cutaway plan view showing a schematic configuration of process fiber 20 according to the first exemplary embodiment. Process fiber 20 shown in FIG. 2 includes the following components: incidence connector 22 connected with processing laser source 12 (FIG. 1); measuring connector 24 connected with measuring laser transceiver 14 (FIG. 1); relay block 25; and emission connector 26 connected with processing head 40 (FIG. 1). Process fiber 20 further includes the following components: incidence-relay fiber 28a extending between incidence connector 22 and relay block 25; relay-emission fiber 28b extending between relay block 25 and emission connector 26; and measuring fiber 36 extending between measuring connector 24 and emission connector 26.

Although not illustrated in detail, incidence-relay fiber 28a includes accordion stainless tube 32 covering the resin-coated processing fiber 30, and coating tube 34 covering stainless tube 32. Accordion stainless tube 32 protects processing fiber 30 from external forces and allows processing fiber 30 to bend to a limited extent. Coating tube 34 may be made, for example, of heat-shrinkable resin.

As shown in FIG. 2, relay-emission fiber 28b includes accordion stainless tube 32 covering processing fiber 30; measuring fiber 36 fixed to stainless tube 32 along its length; and coating tube 34 covering stainless tube 32 and measuring fiber 36. Coating tube 34 of fiber 28b, which can be made of heat-shrinkable resin similar to coating tube 34 of fiber 28a, may be produced by fixing processing fiber 30 (and stainless tube 32) and measuring fiber 36 together.

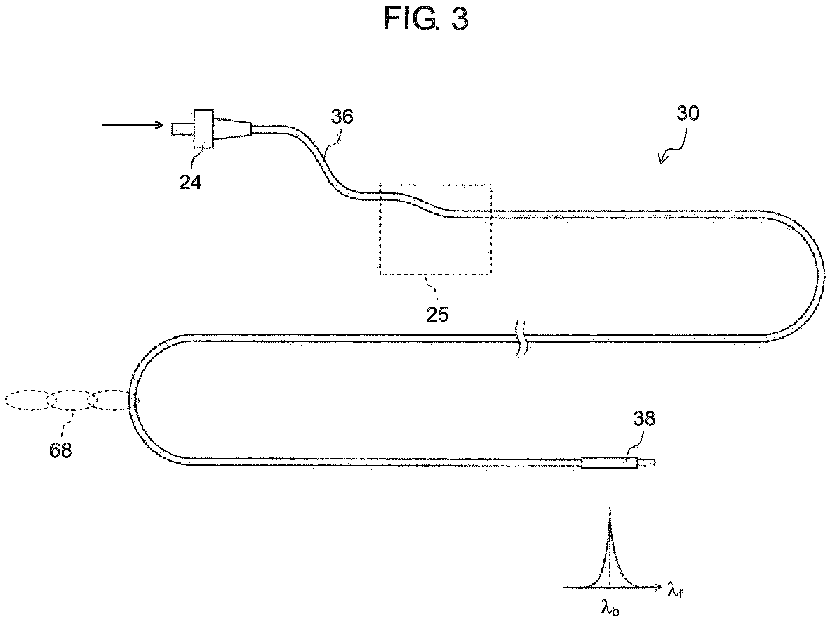

FIG. 3 is a plan view showing a schematic configuration of measuring fiber 36 and measuring connector 24 in the first exemplary embodiment. Measuring fiber 36 is resin-coated for the protection against external forces. Measuring fiber 36 is fixed to stainless tube 32 (FIG. 2) of relay-emission fiber 28b (FIG. 2) along the length of tube 32 in relay block 25 as described above. As will be detailed later, measuring fiber 36 in the first exemplary embodiment includes, as an example of the strain sensor, at least one fiber Bragg grating (hereinafter, FBG) 38, which is located in the vicinity of processing head 40 (FIG. 1). Note that as shown in FIG. 2, measuring fiber 36 is not connected at its distal end (its end near processing head 40) with emission connector 26.

As described above, process fiber 20 according to the present disclosure includes the following components: three connectors (i.e., incidence connector 22, measuring connector 24, emission connector 26); three optical fibers (i.e., incidence-relay fiber 28a, measuring fiber 36, relay-emission fiber 28b); and one relay block 25. The length of each optical fiber can be defined, for example, as follows: the length of incidence-relay fiber 28a is about 0.5 m; the length of measuring fiber 36 as far as relay block 25 is about 2.0 m; and the length of relay-emission fiber 28b is about 19.5 m. As a result, processing fiber 30 of process fiber 20, which corresponds to the distance between incidence connector 22 and emission connector 26, may be about 20 m long, and measuring fiber 36 may be about 21.5 m long.

Measuring fiber 36 is composed of optical fiber wires having a core and a clad, both made of synthesized quartz glass. The core has a refractive index $n_1$ of 1.45 and a diameter of 27.5 pm, while the clad has a refractive index $n_2$ of 1.4492053 and a diameter of 248 $\mu$m. The optical fiber wires may compose a single-mode photonic crystal fiber having a clad outer diameter of 342 $\mu$m and a core numerical aperture (NA) of 0.048. In this case, the optical fiber wires composing measuring fiber 36 having an allowable bending radius R, or in other words, bending radius R with a low transmission loss, can be defined by the following formula.

## Mathematical Formula 1

$$R > ((n_1 + n_2)/(n_1 - n_2)) \cdot d$$

where

    d represents the core diameter,
    $n_1$ represents the core refractive index, and
    $n_2$ represents the clad refractive index.

For Mathematical Formula 1 shown above, please see John A. Buck, FUNDAMENTALS OF OPTICAL FIBERS 2nd ed. Wiley-Interscience, 2004. page 105, Formula (4.18).

Substituting the core diameter d, the core refractive index $n_1$, and the clad refractive index $n_2$ into Mathematical Formula 1 gives an allowable bending radius $R_{MAX}$ of 100.3 mm. In other words, if measuring fiber 36 is bent with a bending radius smaller than the allowable bending radius $R_{MAX}$ of 100.3 mm, the output of the measuring laser beam Ld decreases and the transmission loss greatly increases.

Meanwhile, measuring fiber 36 in the first exemplary embodiment includes at least one FBG 38 as mentioned above. FBG 38 is a fiber diffraction grating device that can periodically change the core refractive index of measuring fiber 36. FBG 38 can be produced, for example, as follows. The resin coated on measuring fiber 36 is partly peeled off, and then the core containing germanium is exposed to strong blue light such that areas with a high refractive index are formed on the core at a predetermined lattice spacing $\Lambda$. After that, in order to protect measuring fiber 36, it is preferable to form a heat-shrinkable resin film in the areas corresponding to the peeled resin as shown in FIG. 3.

FBG 38 reflects only the light having a Bragg wavelength $\lambda_b$ of the measuring laser beam Ld incident on measuring fiber 36. The Bragg wavelength $\lambda_b$ is expressed by Mathematical Formula 2 below using the core refractive index $n_1$ and the lattice spacing $\Lambda$.

## Mathematical Formula 2

$$\lambda_b = 2n_1\Lambda$$

The photodiode detects the reflected beam Lf from FBG 38 of measuring fiber 36. This enables controller 16 to detect an increase in the Bragg wavelength $\lambda_b$ accompanied by the longitudinal straightening of measuring fiber 36 (an increase in the lattice spacing $\Lambda$). Assume, for example, that when the measuring laser beam Ld incident on measuring fiber 36 from the semiconductor laser has a wavelength range including 1550 nm and measuring fiber 36 has no longitudinal straightening, the reflected beam Lf from FBG 38 has a peak center of 1550 nm ($\lambda_b$). When measuring fiber 36 straightens longitudinally, the lattice spacing $\Lambda$ increases so that the peak wavelength of the reflected beam Lf from FBG 38 increases to, for example, 1552 nm ($\lambda_b'$). Meanwhile, when measuring fiber 36 bends, its bending radius R deceases. As a result, the lattice spacing $\Lambda$ increases, thereby increasing the Bragg wavelength $\lambda_b$ of the reflected beam Lf from FBG 38. In other words, detecting the fluctuations in the Bragg wavelength $\lambda_b$ of the reflected beam Lf from FBG 38 results in detecting the fluctuations in the bending radius R of measuring fiber 36 at a predetermined position where FBG 38 is located.

As described above, measuring fiber 36 is fixed integrally to processing fiber 30. Therefore, when measuring fiber 36 bends (or straightens), processing fiber 30 bends (or straightens), too. Thus, according to the present disclosure, the bending radius R or the straightening of processing fiber 30 due to the adjustment of the position and angle of processing head 40 can be detected correctly by detecting the Bragg wavelength $\lambda_b$ of the reflected beam Lf from FBG 38.

Controller 16 according to the present disclosure stores, as a maximum value $\lambda_{bMAX}$, the Bragg wavelength $\lambda_b$ of the reflected beam Lf from FBG 38 when measuring fiber 36 bends with the above-mentioned allowable bending radius $R_{MAX}$ (100.3 mm). As a preliminary test, controller 16 can monitor the Bragg wavelength $\lambda_b$ of the reflected beam Lf from FBG 38 by preventing processing fiber 30 from receiving the processing laser beam Lp and allowing measuring fiber 36 to receive the measuring laser beam Ld. Controller 16 then controls manipulator 50 so as to adjust the position and angle of processing head 40 by the same procedure (with the same program) as the actual processing. In this case, controller 16 determines whether the Bragg wavelength $\lambda_b$ obtained in the monitoring exceeds the maximum value $\lambda_{bMAX}$. If it exceeds the maximum value $\lambda_{bMAX}$, controller 16 determines that measuring fiber 36 and processing fiber 30 bent with a bending radius smaller than the allowable bending radius $R_{MAX}$.

When controller 16 determines that fibers 36 and 30 bent with a bending radius smaller than the allowable bending radius $R_{MAX}$ in the preliminary test, manipulator 50 reviews the procedure (program) of adjusting the position and angle of processing head 40. Controller 16 may repeat the preliminary test until fibers 36 and 30 no longer bend with a bending radius smaller than the allowable bending radius $R_{MAX}$.

In the above description, both fibers 36 and 30 are determined to have bent with a bending radius smaller than the allowable bending radius $R_{MAX}$ when the Bragg wavelength $\lambda_b$ of the reflected beam Lf from FBG 38 exceeds the maximum value $\lambda_{bMAX}$. However, the parameters in Mathematical Formula 1: the core diameter d, the core refractive index $n_1$, and the clad refractive index $n_2$ can be different between fibers 36 and 30. In such cases, controller 16 finds the correlation or proportion between the allowable bending radii, $R_{MAX\ 1}$ and $R_{MAX2}$, respectively, of fibers 36 and 30 obtained in Mathematical Formula 1 based on these parameters. Controller 16 may repeat the preliminary test until processing fiber 30 no longer bends with a bending radius smaller than the allowable bending radius $R_{MAX2}$.

Process fiber 20 (fibers 36 and 30 in particular) tends to bend to the largest degree at a portion near emission connector 26, which is to be connected to processing head 40. Therefore, it is preferable for FBG 38 of measuring fiber 36 to be located in the vicinity of emission connector 26 (e.g., not more than 0.1 m away from emission connector 26). Monitoring the reflected beam Lf from FBG 38 in measuring fiber 36 in real time in this manner can prevent the portion of process fiber 20 that tends to bend to the largest degree from bending to a radius smaller than the allowable bending radius. Furthermore, repeating the preliminary test enables detecting the bending radius of process fiber 20 in real time without, or before, actually laser processing the workpiece. This allows properly programing the operation of manipulator 50 (the movement and angle of the processing head) in advance so as to prevent the bending radius from being smaller than the allowable bending radius $R_{MAX}$.

In the above description, relay-emission fiber 28b contains inside coating tube 34. Tube 34 contains stainless tube 32 covering processing fiber 30, and further contains measuring fiber 36 fixed to stainless tube 32 (FIG. 2). Alternatively, however, in relay-emission fiber 28b, measuring fiber 36 may be fixed to a conventional fiber cable along its length by using, for example, a spiral cable binder. The fiber cable contains coating tube 34, which covers stainless tube 32 covering processing fiber 30. In short, any method can be used to fix fibers 30 and 36 to each other along their length.

## Modified Example of the First Exemplary Embodiment

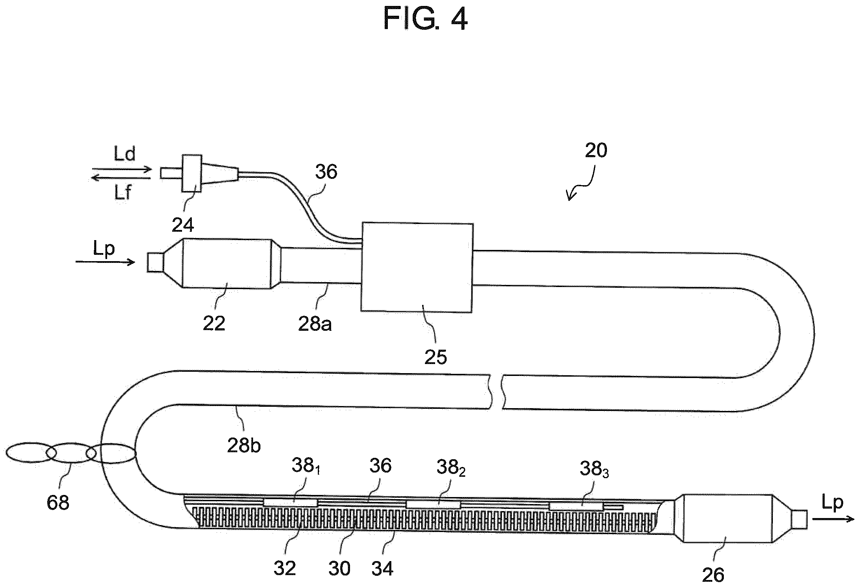

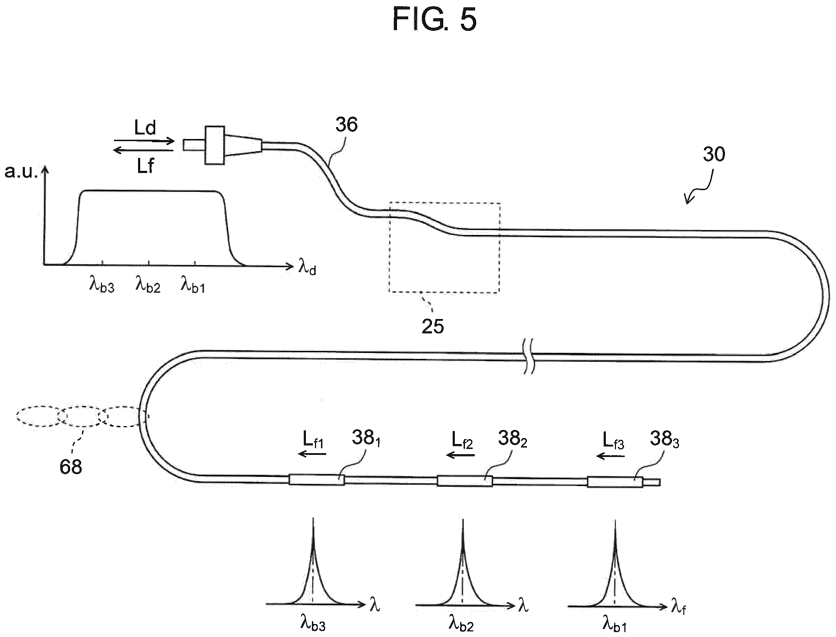

Laser processing system 1 (not shown) according to a modified example of the first exemplary embodiment of the present disclosure will now be described with reference to FIGS. 4 and 5. System 1 (not shown) of this modified example is identical in structure to that in the first exemplary embodiment except in that measuring fiber 36 includes a plurality of FBGs 38. Therefore, the description of the identical components will be omitted.

Measuring fiber 36 shown in FIGS. 2 and 3 has a single FBG 38, but it may alternatively include three FBGs 381, 382, and 383 as shown in FIGS. 4 and 5. FBGs 381, 382, and 383 may be located in the vicinity of emission connector 26 (e.g., away from emission connector 26 by about 0.5 m, about 1.5 m, and about 2.5 m, respectively). It is known that process fiber 20 tends to bend to a large extent at a portion near a position where fiber 20 is hung by fiber holding mechanism 60 (e.g., a position about 4 m away from processing head 40). Therefore, FBGs 381, 382, and 383 may be arranged at regular or appropriate intervals between head 40 and the position where fiber 20 is hung by mechanism 60. Although not illustrated in detail, measuring fiber 36 may alternatively include two, or more than three FBGs 38.

When measuring fiber 36 includes three FBGs 381, 382, and 383, the photodiode emits the measuring laser beam Ld having a wavelength range including wavelengths, for example, from 1520 nm to 1560 nm to measuring fiber 36. FBGs 381, 382, and 383 are configured to reflect light having a peak center of, for example, 1520 nm ($\lambda_b$ 1), 1525 nm ($\lambda_b$ 2), and 1530 nm ($\lambda_b$ 3), respectively. As mentioned above, the value of each of the Bragg wavelengths $\lambda_b$ 1, $\lambda_b$ 2, and $\lambda_b$ 3 can be arbitrarily determined by applying strong blue light to the core, and adjusting the lattice spacing $\Lambda$ in the areas with a high refractive index.

When process fiber 20 containing measuring fiber 36 bends, the reflected beams Lf from FBGs 381, 382, and 383 increase to, for example, 1522 nm ($\lambda_b$ 1'), 1527 nm ($\lambda_b$ 2'), and 1532 nm ($\lambda_b$ 3'), respectively. The increase in each Bragg wavelength $\lambda_b$ of the reflected beams Lf from FBGs 381, 382, and 383 can be related to the allowable bending radius $R_{MAX2}$ of processing fiber 30 in the positions where FBGs 381, 382, and 383 are located, similar to the first exemplary embodiment.

The reflected beams Lf from FBGs 381, 382, and 383 in measuring fiber 36 in the modified example of the first exemplary embodiment are monitored in real time. This can prevent the plurality of portions of process fiber 20 that tend to bend to a large degree from bending to a radius smaller than the allowable bending radius. Similar to the first exemplary embodiment, a preliminary test is repeated before actually laser processing the workpiece. This allows properly programming the operation of manipulator 50 such that process fiber 20 is prevented from bending at any portions to a radius smaller than the allowable bending radius.

## SECOND EXEMPLARY EMBODIMENT

Laser processing system 1 according to a second exemplary embodiment of the present disclosure will now be described as follows. In the first exemplary embodiment, the reflected beam Lf from measuring fiber 36 is detected by using the FBG, which is a fiber diffraction grating device. On the other hand, the second exemplary embodiment uses Rayleigh-scattering distributed sensing (hereinafter, FBI-Gauge system). The other structures are identical to those in the first exemplary embodiment, and their description will be omitted.

Although not illustrated in detail, measuring laser transceiver 14 in the second exemplary embodiment includes a wavelength-variable laser that emits a laser beam (a measurement beam) to measuring fiber 36. The wavelength of the laser beam changes periodically, for example, between 1510 nm and 1570 nm. Transceiver 14 further includes a detection device that detects, using a spectrometer, the measurement beam (a reference beam) emitted from the wavelength-variable laser. This detection device detects, using a different spectrometer, the Rayleigh scattered light (reflected beam Lf) generated from the measurement beam in measuring fiber 36. In short, the detection device is configured to detect the reference beam and the measurement beam so as to detect the intensity change caused by the interference between these beams.

Controller 16 in the second exemplary embodiment is configured to Fourier-transform the interference between the reference beam and the measurement beam detected by the detection device and to determine the scattered light frequency depending on a position along the length of measuring fiber 36.

In general, the glass molecules composing an optical fiber have density variations. Such density variations are unique to each optical fiber. In short, optical fibers differ in the wavelength of strongly Rayleigh scattered light because of the density variations in different positions along the length of the fibers. Therefore, the wavelength change in the Rayleigh scattered light at each position of the optical fiber is called the unique fingerprint information of the optical fiber. If there is a stain in a specific position of the optical fiber, the wavelength of the Rayleigh scattered light corresponding to the specific position is shifted (the unique fingerprint information of the optical fiber is changed).

Controller 16 in the second exemplary embodiment stores the unique fingerprint information of measuring fiber 36 measured before measuring fiber 36 is strained. Controller 16 then detects the amount of strain (the amount of straightening and bending) depending on a position along the length of measuring fiber 36, based on the unique fingerprint information changed during the preliminary test (when measuring fiber 36 is strained) in the same manner as in the first exemplary embodiment. Thus, measuring laser transceiver 14 (including the wavelength-variable light source) and controller 16 in the second exemplary embodiment together form the FBI-Gauge system. Comparing the reflected beams Lf (the unique fingerprint information) before and after measuring fiber 36 bends can detect the amount of strain (the amount of straightening and bending) at any position in measuring fiber 36.

Controller 16 in the second exemplary embodiment detects the allowable bending radius $R_{MAX2}$ at any position in processing fiber 30. Controller 16 in the second exemplary embodiment is identical in structure to that in the first exemplary embodiment and will not be described in detail. Furthermore, controller 16 in the second exemplary embodiment can prevent processing fiber 30 from bending, at any position, to a radius smaller than the allowable bending radius $R_{MAX2}$. Similar to the first exemplary embodiment, repeating the preliminary test allows properly programming the operation of manipulator 50 such that process fiber 20 is prevented from bending at any position to a radius smaller than the allowable bending radius before actually laser processing the workpiece W.

## Industrial Applicability

The present disclosure is useful as a process fiber not bending to a radius smaller than the allowable bending radius, and to a laser processing system including the process fiber.

**REFERENCE MARKS IN THE DRAWINGS**

| | |
|---|---|
| 1 | laser processing system |
| 10 | laser oscillator |
| 12 | processing laser source |
| 14 | measuring laser transceiver (measuring laser source) |
| 16 | controller |
| 20 | process fiber |
| 22 | incidence connector |
| 24 | measuring connector |
| 25 | relay block |
| 26 | emission connector |
| 28a | incidence-relay fiber |
| 28b | relay-emission fiber |
| 30 | processing fiber (first light transmitter) |
| 32 | stainless tube |
| 34 | coated tube |
| 36 | measuring fiber (second light transmitter) |
| 38, 381, 382, 383 | fiber Bragg grating(FBG) |
| 40 | processing head |
| 50 | manipulator |
| 60 | fiber holding mechanism |
| 62 | base |
| 64 | column |
| 66 | arm |
| 68 | hook |
| W | workpiece |

**Claims**

1. A process fiber comprising:

a first light transmitter configured to transmit a processing laser beam emitted from a processing laser source of a laser processing system;
a measuring laser source configured to emit a measuring laser beam; and
a second light transmitter including a reflection part configured to reflect the measuring laser beam, the second light transmitter being fixed to the first light transmitter along a length of the first light transmitter and being configured to transmit the measuring laser beam,
wherein a bending radius of the first light transmitter at a predetermined position is detected based on the measuring laser beam reflected by the reflection part.

2. The process fiber according to claim 1, wherein
the second light transmitter comprises at least one strain sensor provided as the reflection part at the predetermined position, the at least one strain sensor being configured to reflect the measuring laser beam having a specific peak wavelength, and
the bending radius of the first light transmitter at the predetermined position is detected based on the measuring laser beam reflected by the at least one strain sensor.

3. The process fiber according to claim 2, wherein the second light transmitter comprises a photonic crystal fiber.

4. The process fiber according to claim 2 or 3, wherein the at least one strain sensor comprises fiber Bragg grating, the fiber Bragg grating being configured to reflect the measuring laser beam having a specific wavelength.

5. The process fiber according to claim 2, wherein
the at least one strain sensor comprises a plurality of strain sensors, and

the plurality of strain sensors are configured to reflect a plurality of measuring laser beams each having a specific wavelength,
wherein
bending radii of the first light transmitter at a plurality of predetermined positions are detected based on the plurality of measuring laser beams reflected by the plurality of strain sensors.

6. The process fiber according to claim 1, wherein
the measuring laser source is a wavelength-variable light source, and
the bending radius of the first light transmitter at the predetermined position is detected based on Rayleigh scattered light reflected by the second light transmitter.

7. The process fiber according to any one of claims 1 to 6, wherein
a position and orientation of a processing head located at an emission end of the first light transmitter is controlled, and either the bending radius of the first light transmitter at the predetermined position or the bending radii of the first light transmitter at the plurality of predetermined positions are detected, the predetermined position and the plurality of predetermined positions being in a vicinity of the processing head.

8. A laser processing system comprising:

   a processing laser source configured to emit a processing laser beam;
   a first light transmitter configured to transmit the processing laser beam emitted from the processing laser source;
   a measuring laser source configured to emit a measuring laser beam;
   a second light transmitter including a reflection part configured to reflect the measuring laser beam, the second light transmitter being fixed to the first light transmitter along a length of the first light transmitter and being configured to transmit the measuring laser beam; and
   a controller configured to detect a bending radius of the first light transmitter at a predetermined position based on the measuring laser beam reflected by the reflection part.

9. The laser processing system according to claim 8, wherein
the second light transmitter comprises at least one strain sensor provided as the reflection part at the predetermined position, the at least one strain sensor being configured to reflect the measuring laser beam having a specific peak wavelength, and
the controller detects the bending radius of the first light transmitter at the predetermined position based on the measuring laser beam reflected by the at least one strain sensor.

10. The laser processing system according to claim 9, wherein the second light transmitter comprises a photonic crystal fiber.

11. The laser processing system according to claim 9 or 10, wherein the at least one strain sensor comprises fiber Bragg grating, the fiber Bragg grating being configured to reflect the measuring laser beam having a specific wavelength.

12. The laser processing system according to claim 9, wherein
the at least one strain sensor comprises a plurality of strain sensors,
the plurality of strain sensors are configured to reflect a plurality of measuring laser beams each having a specific wavelength, and
the controller detects bending radii of the first light transmitter at a plurality of predetermined positions based on the plurality of measuring laser beams reflected by the plurality of strain sensors.

13. The laser processing system according to claim 8, wherein
the measuring laser source is a wavelength-variable light source, and
the controller detects the bending radius of the first light transmitter at the predetermined position based on Rayleigh scattered light reflected by the second light transmitter.

14. The laser processing system according to any one of claims 8 to 13, further comprising:

   a processing head located at an emission end of the first light transmitter; and
   a manipulator configured to adjust a position and orientation of the processing head,

wherein the controller controls the manipulator so as to detect either the bending radius of the first light transmitter at the predetermined position or the bending radii of the first light transmitter at the plurality of predetermined positions, the predetermined position and the plurality of predetermined positions being in a vicinity of the processing head.

FIG. 1

FIG. 2

# FIG. 3

EP 3 685 955 A1

# FIG. 4

EP 3 685 955 A1

FIG. 5

<table>
<tr><td colspan="2">**INTERNATIONAL SEARCH REPORT**</td><td colspan="2">International application No.<br>PCT/JP2018/033522</td></tr>
</table>

A.  CLASSIFICATION OF SUBJECT MATTER
Int.Cl.  B23K26/064(2014.01)i, B23K26/00(2014.01)i, G02B26/02(2006.01)i

According to International Patent Classification (IPC) or to both national classification and IPC

B.  FIELDS SEARCHED

Minimum documentation searched (classification system followed by classification symbols)
Int.Cl.  B23K26/064, B23K26/00, G02B26/02

Documentation searched other than minimum documentation to the extent that such documents are included in the fields searched

| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 59-195891 A (MATSUSHITA ELECTRIC INDUSTRIAL CO., LTD.) 07 November 1984, page 2, fig. 1-4 (Family: none) | 1-14 |
| Y | WO 2016/117090 A1 (OLYMPUS CORP.) 28 July 2016, claims, paragraph [0044], fig. 2-15 & US 2017/0311775 A1, claims, paragraph [0087], fig. 2-15 | 1-14 |
| Y | JP 2016-502412 A (KONINKLIJKE PHILIPS N.V.) 28 January 2016, paragraphs [0035], [0037], fig. 3, 5-6 & US 2015/0254526 A1 & WO 2014/053925 A1, paragraphs [0035], [0037], fig. 3, 5-6 & CN 104703558 A | 1-14 |

☒  Further documents are listed in the continuation of Box C.          ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 03 December 2018 (03.12.2018) | 11 December 2018 (11.12.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2018/033522

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2009-129987 A (HITACHI CABLE LTD.) 11 June 2009, paragraphs [0019]-[0036], fig. 1-3 (Family: none) | 3-4, 7, 10-11, 14 |
| Y | JP 10-211594 A (MITSUBISHI ELECTRIC CORP.) 11 August 1998, paragraphs [0002]-[0004], fig. 11 (Family: none) | 7, 14 |

Form PCT/ISA/210 (continuation of second sheet) (January 2015)

**EP 3 685 955 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010214437 A

- JP 60019007 A

**Non-patent literature cited in the description**

- **JOHN A. BUCK.** FUNDAMENTALS OF OPTICAL FIBERS. Wiley-Interscience, 2004, 105